# EUROPEAN PATENT APPLICATION

(11) **EP 2 306 796 A1**
(43) Date of publication of application: **06.04.2011**
(21) Application number: 09172201.7
(22) Date of filing: 05.10.2009
(51) Int. Cl.: H05K 3/32

(54) **Method of joining components, composite of components of an electrical circuit and electrical circuit**

(71) Applicant: ABB Research Ltd., 8050 Zürich (CH)
(72) Inventor: Chunlei, Liu, CH-8051, Zürich (CH); Kicin, Slavo, CH-8049, Zürich (CH); Schulz, Nicola, CH-5300, Turgi (CH)
(74) Representative: ABB Patent Attorneys

(57) **Abstract**

The invention relates to a method of joining at least two components (12, 16, 36) of an electrical circuit module (30) for establishing a mechanical and electrical interconnection between the components (12, 16, 36), wherein the joining is realized by a sintering process for sintering a metal joint (26, 34) between the components (12, 16, 36) and wherein ultrasonic vibration energy is supplied at least temporarily during the sintering process for supporting said sintering process.

The invention further relates to a corresponding composite (10) comprising at least two components (12, 16, 36) of an electrical circuit module (30) and a corresponding electrical circuit module (30).

## Description

### Technical Field

The invention relates to a method of joining at least two components of an electrical circuit module for establishing a mechanical and electrical interconnection between the components. The invention further relates to a corresponding composite of components of an electrical circuit and an electrical circuit module.

### Background Art

There are many joints or interconnections/bonds between components needed in electrical circuit modules, e.g. electronic circuit modules or semiconductor packaging like microelectronic packaging, power electronics packaging, even LED packaging. Die-attach, wire bonding are the first level packaging and these joints are usually the most critical and also the weakest points of the whole package. The trend of power electronics goes toward higher power density, higher operation temperature and higher reliability requirement and new wide band gap semiconductors materials like e.g. SiC, GaN also require advanced packaging for higher operation temperature and higher reliability. Semiconductor packaging is now becoming the bottleneck for high power and high performance power electronics system.

### Summary of invention

It is an object of the present invention to provide a method of joining components of an electrical circuit module, a corresponding composite of components of an electrical circuit module and an electrical circuit module which enables higher operation temperature and higher reliability compared to conventional electrical circuits.

This object is achieved by the features of the independent claims. Preferred embodiments are given by the dependent claims.

The joining is realized by a sintering process for sintering a metal joint between the components, wherein ultrasonic vibration energy is supplied at least temporarily during the sintering process for supporting said sintering process. Metal sintered joints like for example Ag sintered joints offer much higher operation temperature and higher reliability compared to a conventional circuit module using soldering and wire bonding techniques. In comparison to soldered (die-)bonds and wire bonding, the Ag sintered joint shows better electrical, thermal and mechanical properties, which result in higher power density capability, higher operating temperature capability and higher reliability. However the bonding or joining-by-sintering process of metals like Ag is not trivial since both sintering pressure (1-40 MPa) and sintering temperature or sintering heat (around 200°C - 350°C) are needed during this sintering process. Usually this sintering is done using a press that has an integrated heating. Because heat must be maintained for a plurality of minutes, the throughput of a single bonding apparatus is limited.

Sintered joints offer much higher operation temperature and higher reliability compared to conventional packaging using soldering and wire bonding techniques. However, a sintering process that usually involves applying high pressure and heat is difficult to implement for mass production because both the heat and the pressure must be maintained simultaneously for some minutes. Therefore the sintering process according to the invention is driven by the applied sintering pressure, sintering temperature and additionally by induced ultrasonic vibration energy. To reduce the necessary sintering pressure, sintering time and/or sintering temperature, ultrasonic vibration energy is supplied to the metal joint by inducing high frequency ultrasound. With respect to the present invention, the term "metal joint" relates to a mechanical as well as an electrical interconnection (or bond) between at least two components.

Ultrasonic technique and ultrasonic equipment are well established and used in the semiconductor industry for many years. In metals, ultrasonic sintering occurs due to high-pressure dispersion of surface oxides, local motion of the materials and also local heating. For example Al wire bonding using ultrasonic vibration energy and even ultrasonic welding of Cu terminal to substrate in power electronics packaging. Up-to-date ultrasonic equipment is very fast and can easily be automated and also enables clean and precise joints.

According to a first embodiment of the present invention, the metal is Ag or at least comprises Ag. Ag sintering is a well known low temperature bonding method.

According to another embodiment of the invention, a tool for applying the sintering pressure and/or temperature is further used for supplying the ultrasonic vibration energy to the emerging joint. The device especially is a tip of a pressing tool of the ultrasonic equipment. The pressing tool preferably comprises a sonotrode, which is exposed to ultrasonic vibration, and transfers the ultrasonic vibration energy into a joining area of the components.

According to another embodiment of the invention, metal particles, especially nano-sized metal particles, are sintered to form a sintered metal joint. The particles especially are Ag and/or nano-Ag particles, which are sintered to form an Ag sintered joint.

According to another embodiment of the invention, the method further comprises a step of printing and/or dispensing a suspension comprising the metal particles on a joining area of at least one of the components for the adjacent joining of the components.

According to yet another embodiment of the invention, at least two sintered metal joints are generated by one sintering process.

According to a preferred embodiment of the invention, the electrical circuit module is an electronic circuit module, preferably a microelectronic module, power electronics module, LED module (LED: Light Emitting Diode) or similar modules, especially semiconductor packaging like microelectronic packaging, power electronics packaging or even LED packaging.

According to another preferred embodiment of the present invention, at least one of the components is a semiconductor device .

According to yet another preferred embodiment of the present invention, at least one of the components comprises a noble metal coating on its outer surface in the region where the sintered joint is formed. This region is substantially located in the joining area.

The invention further relates to a composite comprising at least two components of an electrical circuit module, wherein the components are mechanically and electrically interconnected by at least one joint. According to the invention the composite is manufactured by joining the components using an aforementioned method, wherein the joint is a sintered metal joint.

The method utilizes well established ultrasonic technology to assist the metal sintering and to form a sintered metal joint. The use of ultrasonic vibration energy speeds up the sintering process and can be easily automated for the mass production. Metal particles, especially nano-sized metal particles, are sintered to form the sintered metal joint.

According to an embodiment of the present invention, the metal of the sintered metal joint is Ag or comprises Ag. The particles especially are Ag and/or nano-Ag particles, which are sintered to form an Ag sintered joint. Ultrasonic Ag/nano-Ag sintering can then replace the soft-soldering and also wire bonding for next generation high performance semiconductor packaging.

According to another embodiment of the present invention, at least one of the components is a semiconductor device.

The invention further relates to an electrical circuit module comprising at least one aforementioned composite. Preferably the electrical circuit module is an electronic circuit module.

### Brief description of drawings

These and other aspects of the invention will be apparent from and elucidated with reference to the embodiments described hereinafter. In the drawings:

Fig. 1 shows a composite of components for an electronic circuit module according to a first embodiment of the invention;

Fig. 2 shows an electronic circuit module comprising four composites according to a second embodiment of the invention; and

Fig. 3 depicts a sectional view of the electronic circuit module shown in Fig. 2; and one of the composites of said electronic circuit module in detail.

### Description of embodiments

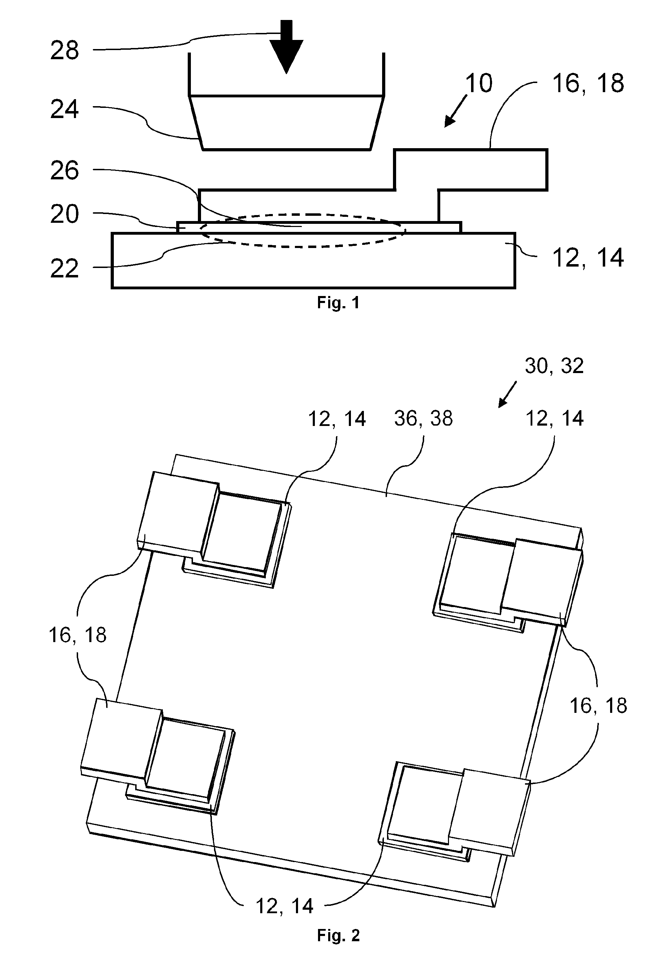

Fig. 1 shows a composite 10 of a first component 12 being a semiconductor device 14 and a second component 16 being a contact device 18 formed as a metal ribbon. Between the upper side of the semiconductor device 14 and the lower side of the contact device 18 a layer 20 of a paste comprising metal particles being Ag particles and/or Ag nano-particles is located. By applying sinter pressure, sinter heat (sinter temperature) and additionally by supplying induced ultrasonic vibration energy to a joining area 22 by a sintering tool 24, a sintered metal joint 26 is formed. This sintered metal joint 26 mechanically and electrically interconnects the first and second component 12, 16 of the composite 10.

The sintering tool 24 compresses the layer 20 comprising the Ag particles and/or Ag nano-particles by single action pressing (arrow 28) in combination with heating and supplying the ultrasonic vibration energy, wherein the sintered metal joint 26 (sintered Ag joint) originates.

As shown in Fig. 1, the top of first component 14 being the semiconductor device 12 (or chip, especially an emitter of IGBT (IGBT: Insulated Gate Bipolar Transistor) or a cathode in a diode) is sintered with the second component 16 (a ribbon) by ultrasonic Ag/nano-Ag sintering. The sintering process is done by using the ultrasonic equipment of the tool 24 as following:

1. Stencil/screen printing or dispensing the layer 20 of the Ag/nano-Ag paste on the selected top area of a semiconductor device 14 (not shown).

2. Picking and placing the ribbon, especially Al ribbon or Cu ribbon, preferable comprising a noble metal plating (e.g, Ag plating or Au plating), sintering, wherein the sintering process will be initiated and finished by the supplied ultrasonic vibration energy (ultrasonic energy), local heat and pressure generated by appropriate tool 24. Additional external heating is also an option to accelerate the sintering process (not shown).

3. Ultrasonic bonding of the ribbon to a metallization of a substrate (not shown in Fig. 1) can be done by using the same equipment/tool with appropriate parameters.

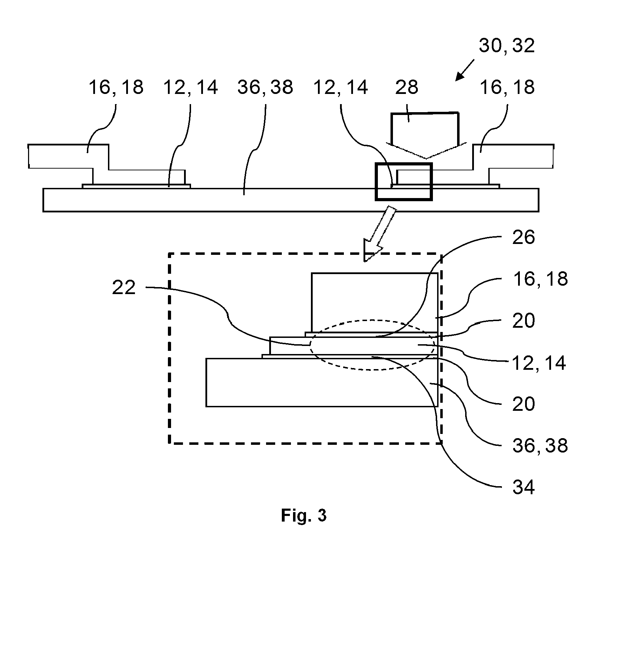

Figs. 2 and 3 are illustrating an electrical circuit module 30 comprising four composites 10 according to a second embodiment of the invention. The electrical circuit module 30 shown in Figs. 2 to 4 is an electronic circuit module 32. Each composite 10 comprises two sintered metal joints 26, 34, which are generated by one single sintering process using the one sintering tool 24. Fig. 3 shows a sandwich-structure of the first component 12 being a semiconductor device 14 located between the second component 16 being a contact device 18 on the upper side of the first component 12 and a third component 36 being a metalized substrate 38 of the electronic circuit module 32 beneath a lower side of the first component 12. Between the first component 12 and the second component 16 and the first component 12 and the third component 36 respectively, a layer 20 of a paste comprising Ag particles and/or Ag nano-particles is located.

By applying sinter pressure, sinter heat (sinter temperature) and additionally by supplying induced ultrasonic vibration energy to a joining area 22 by the sintering tool 24, the two sintered metal joints 26, 34 are formed simultaneously. The one sintered metal joint 26 mechanically and electrically interconnects the first and second component 12, 16 of the composite 10, the further sintered metal joint 34 mechanically and electrically interconnects the first and third component 12, 36 of the composite 10.

Using the ultrasonic equipment of the tool 24 to supply the ultrasonic vibration energy, local heat and also pressure to desired joining interface (or bond interface). The whole joining process can be described as following:

1. Stencil/screen printing or dispensing Ag/nano-Ag paste on the substrate and ribbon bottom (not shown).

2. Drying the organic binder through burn out processes (This step can be combined with the step 3, e.g. drying organic binder after placing the semiconductor device 12 and contact device 16.)

3. Picking and placing the semiconductor device 12 and contact device 16 and applying the ultrasonic vibration energy, local heat and pressure to assist sintering of Ag/nano-Ag particles within the layers 20 at the bottom and top interface of the semiconductor device 12 at the same time.

4. Additional external heating from the bottom of the semiconductor device 12 is optional to accelerate the sintering and diffusion process. The final electronic circuit module 32 with the double-side sintered semiconductor devices 12 is illustrated in Fig. 2.

Alternative procedure (not shown):

1. Stencil/screen printing or dispensing Ag/nano-Ag paste on the substrate 38.

2. Drying the organic binder through burn out processes (This step can be combined with the step 3, e.g. drying organic binder after placing the semiconductor devices 14.)

3. Picking and placing the semiconductor devices 14 (chips) and use ultrasonic machine to apply the ultrasonic vibration energy, local heat and pressure to assist sintering of Ag/nano-Ag particles.

4. Additional external heating from the bottom of the semiconductor devices 14 is an optional to accelerate the sintering and diffusion process.

5. Following the procedure of Fig. 1 to make the ribbon bonding at the top of the semiconductor devices 14 (chips) by ultrasonic Ag sintering. The final double-side metal sintered semiconductor device 14 (chip) is illustrated in Fig. 2.

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: composite of components
- 12: first component
- 14: semiconductor device
- 16: second component
- 18: contact device
- 20: layer comprising metal particles
- 22: joining area
- 24: sintering tool
- 26: sintered metal joint
- 28: arrow
- 30: electrical circuit module
- 32: electronic circuit module
- 34: further sintered metal joint
- 36: third component
- 38: metalized substrate

## Claims

1. Method of joining at least two components of an electrical circuit module for establishing a mechanical and electrical interconnection between the components, wherein the joining is realized by a sintering process for sintering a metal joint between the components and ultrasonic vibration energy is supplied at least temporarily during the sintering process for supporting said sintering process.

2. Method according to claim 1, wherein the metal is Ag or at least comprises Ag.

3. Method according to any of the preceding claims, wherein a tool for applying the sintering pressure and/or sintering temperature is further used for supplying the ultrasonic vibration energy to the emerging joint.

4. Method according to any of the preceding claims, wherein metal particles, especially nano-sized metal particles, are sintered to form a sintered metal joint.

5. Method according to claim 4, further comprising a step of printing and/or dispensing a suspension comprising the metal particles on a joining area of at least one of the components for the adjacent joining of the components.

6. Method according to any of the preceding claims, wherein at least two sintered metal joints are generated by one sintering process.

7. Method according to any of the preceding claims, wherein the electrical circuit module is an electronic circuit module.

8. Method according to any of the preceding claims, wherein at least one of the components is a semiconductor device.

9. Method according to any of the preceding claims, wherein at least one of the components comprises a noble metal coating on its outer surface in the region where the sintered joint is formed.

10. Composite (10) comprising at least two components (12, 16, 36) of an electrical circuit module (30), wherein the components (12, 16, 36) are mechanically and electrically interconnected by at least one joint, **characterised in that** the composite (10) is manufactured by joining the components using a method according to any of the preceding claims, wherein the joint is a sintered metal joint (12, 16, 36).

11. Composite according to claim 10, wherein the metal of the sintered metal joint (12, 16, 36) is a sintered Ag joint or a sintered metal joint comprising Ag.

12. Composite according to claim 10 or 11, wherein at least one of the components (12) is a semiconductor device (14).

13. Electrical circuit module (30) comprising at least one composite (10) according to one of claims 10 to 12.

14. Electrical circuit module according to claim 13, wherein the electrical circuit module (30) is an electronic circuit module (32).
